Europäisches Patentamt

European Patent Office

Office européen des brevets

(19)

(11) Numéro de publication : **0 165 085 B1**

(12) **FASCICULE DE BREVET EUROPÉEN**

(45) Date de publication du fascicule du brevet :
09.08.89

(51) Int. Cl.⁴ : **H 01 L 21/60**

(21) Numéro de dépôt : **85400706.9**

(22) Date de dépôt : **09.04.85**

(54) Procédé de réalisation de contacts d'aluminium à travers une couche isolante épaisse dans un circuit intégré.

(30) Priorité : 13.04.84 FR 8405906

(43) Date de publication de la demande :
18.12.85 Bulletin 85/51

(45) Mention de la délivrance du brevet :
09.08.89 Bulletin 89/32

(84) Etats contractants désignés :
DE FR GB IT NL

(56) Documents cités :
EP–A– 0 068 897
EP–A– 0 070 737
EP–A– 0 119 497
US–A– 4 392 298
PATENTS ABSTRACTS OF JAPAN, vol. 6, no. 9 (E-90) [887], 20 janvier 1982, page 25 E 90 & JP - A - 56 130 920

(73) Titulaire : SGS-THOMSON MICROELECTRONICS S.A.
7, Avenue Galliéni
F-94250 Gentilly (FR)

(72) Inventeur : Deleonibus, Simon
THOMSON-CSF SCPI 173, bld Haussman
F-75379 Paris Cedex 08 (FR)
Inventeur : Dubois, Guy,
THOMSON-CSF SCPI 173, bld Haussman
F-75379 Paris Cedex 08 (FR)

(74) Mandataire : Rinuy, Santarelli
14, avenue de la Grande Armée
F-75017 Paris (FR)

## Description

Il est fréquent, dans la réalisation de circuits intégrés, que l'on utilise une couche d'interconnexion en aluminium (bon conducteur, facile à déposer et à graver) pour relier entre eux les divers éléments du circuit intégré ; cette couche repose généralement sur une couche isolante relativement épaisse (de l'ordre de un micron ou plus) au-dessous de laquelle se trouvent les éléments du circuit intégré. La couche isolante est ouverte avant le dépôt de l'aluminium pour mettre à nu les surfaces avec lesquelles on désire établir une interconnexion métallique ; ces surfaces peuvent être des surfaces de silicium monocristallin (sources et drains, collecteurs, bases, émetteurs de transistors), ou de silicium polycristallin (grilles de transistors à effet de champ), ou encore, pourquoi pas, des surfaces métalliques d'une autre couche d'interconnexion.

L'épaisseur importante de la couche isolante résulte de la nécessité de réduire les capacités parasites entre les conducteurs d'interconnexion et les éléments de circuit au-dessus desquels ils passent.

Malheureusement, cette épaisseur rend difficile l'obtention de surfaces de contacts très petites et très rapprochées entre la couche d'interconnexion et les éléments de circuit.

En effet, si on désire des surfaces de contact étroites et rapprochées, on est amené à graver directivement (verticalement) les ouvertures de contact dans la couche isolante. Mais alors, si on ne prend pas des précautions spéciales, cette gravure directive donne aux bords des ouvertures une forme abrupte qui risque de provoquer des cassures de l'aluminium lors de son dépôt par évaporation. Les précautions que l'on peut prendre consistent notamment en un dépôt de la couche isolante en deux étapes et une gravure de la couche également en deux étapes ; mais ces précautions conduisent à un accroissement du pas entre conducteurs (pas ≟ largeur + espacement) au niveau des contacts.

La présente invention propose une solution pour, d'une part, éviter le risque de cassure de l'aluminium et, d'autre part, éviter l'augmentation du pas entre conducteurs ou même réduire ce pas. Cette invention est généralement applicable à la formation d'une couche d'interconnexion en métal autre que l'aluminium, mais déposé comme lui par évaporation et donc sujet comme lui à un risque important de cassure au niveau d'un bord abrupt.

La présente invention prévoit un procédé de fabrication d'une couche d'interconnexion dans un circuit intégré, comprenant les étapes consistant à déposer une couche isolante relativement épaisse sur un substrat incorporant des éléments de circuit intégré déjà réalisés, graver une ouverture de contact étroite dans cette couche, déposer par évaporation et graver un métal d'interconnexion, caractérisé en ce que, après la gravure des ouvertures de contact étroites et avant le dépôt par évaporation du métal d'interconnexion, on dépose, de façon à obtenir un fort pouvoir couvrant sur les surfaces verticales comme sur les surfaces horizontales, par décomposition chimique en phase gazeuse un matériau conducteur, le dépôt étant effectué sur une épaisseur suffisante pour que la totalité du volume de l'ouverture de contact étroite soit remplie de matériau conducteur et pour que l'épaisseur de ce matériau à l'aplomb de l'ouverture soit nettement supérieure à l'épaisseur au-dessus de la couche isolante, on grave alors ce matériau par gravure anisotrope verticale, sur une épaisseur uniforme correspondant sensiblement à l'épaisseur déposée sur l'ensemble de la couche isolante, de manière à éliminer le matériau conducteur en dehors de l'ouverture en ne l'éliminant que dans une faible proportion à l'intérieur de l'ouverture.

Le matériau conducteur que l'on peut déposer est du silicium polycristallin, du titane, du tungstène, du molybdène. On peut même envisager de déposer comme matériau conducteur, dans certains cas, une première couche d'aluminium, à condition de la déposer par décomposition chimique en phase gazeuse et non pas par évaporation.

Le document EP-A-0 119 497 opposable au titre de l'article 54 (3) de la CBE pour DE, FR, GB, IT enseigne le procédé selon l'invention dans le cas où le matériau conducteur est du silicium polycristallin. En conséquence, ce matériau est explicitement exclu de la revendication 1 dans les revendications déposées pour ces pays.

Les dimensions latérales des ouvertures étroites sont de préférence de l'ordre de un à deux microns environ.

D'autres caractéristiques et avantages de l'invention apparaîtront à la lecture de la description détaillée qui suit et qui est faite en référence aux dessins annexés dans lesquels :

la figure 1 représente une ouverture de contact montrant le risque de cassure de l'aluminium ;

la figure 2 représente une solution connue pour limiter le risque de cassure ;

les figures 3 à 7 montrent les étapes successives de réalisation des interconnexions selon l'invention ;

la figure 8 représente schématiquement la diminution d'encombrement permise par l'invention pour une largeur de contact minimale déterminée.

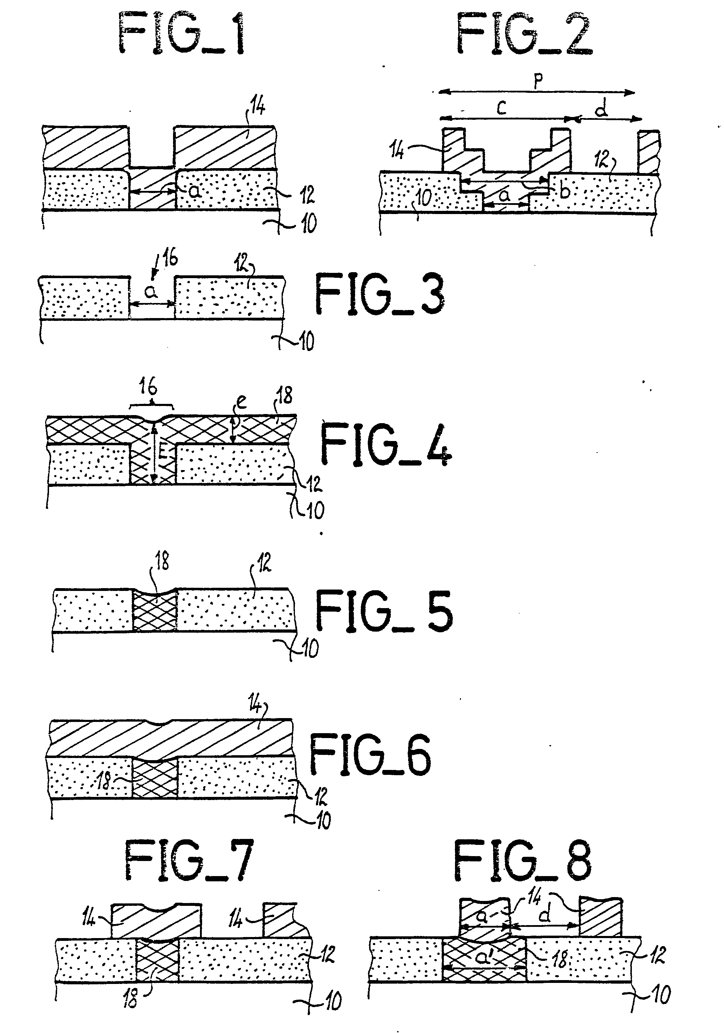

Sur la figure 1, un substrat semiconducteur (silicium) incorporant des éléments de circuit non représentés est désigné par la référence 10. Ce substrat a été recouvert d'une couche isolante (oxyde de silicium) 12 dans laquelle on a gravé une ouverture de contact avant de déposer, par évaporation, une couche conductrice d'interconnexion 14 en aluminium destinée à être gravée pour définir un motif d'interconnexion.

Si l'épaisseur de la couche isolante 12 est importante (et en particulier du même ordre de grandeur que la couche métallique 14), l'aluminium déposé par évaporation se dépose sur la couche isolante et au fond de l'ouverture de contact, avec un amincissement ou même un risque de rupture totale entre les deux, car l'aluminium déposé par évaporation passe très mal les marches abruptes (faible pouvoir couvrant sur les bords verticaux).

Pour éviter ce risque, on a par exemple adopté un procédé expliqué en référence à la figure 2 : la couche isolante 12 est déposée en deux ou plusieurs couches d'épaisseur beaucoup moins importante que l'épaisseur finale désirée. Par exemple, une première couche ayant la moitié de l'épaisseur finale désirée est déposée et gravée de manière à former une ouverture de contact ayant la largeur a désirée ; puis une deuxième couche isolante est déposée pour obtenir l'épaisseur totale désirée ; cette deuxième couche est gravée (pendant une durée contrôlée pour ne pas attaquer la première couche, les deux couches ayant de préférence des dopages en impuretés différents de manière que la première couche soit plus difficile à graver que la seconde) ; la gravure de la deuxième couche se fait au-dessus de la première ouverture de contact mais sur une largeur b plus grande que la largeur a avec une marge suffisante pour assurer de tous les côtés de l'ouverture de contact, malgré les dispersions de positionnement, une double marche au lieu d'une marche unique comme dans le cas de la figure 1. Puis, l'aluminium est déposé et passe relativement bien ces doubles marches d'épaisseur beaucoup plus faible (la moitié) qu'à la figure 1. L'aluminium peut être gravé mais en conservant au-dessus de l'ouverture de contact une largeur c supérieure a la largeur b pour assurer, malgré les dispersions de positionnement, que l'aluminium recouvre totalement les deux marches de la couche isolante. Si l'espacement minimum entre deux conducteurs voisins est d, le pas des conducteurs est nécessairement $p = c + d$.

Le procédé selon la présente invention va maintenant être décrit.

A la figure 3, on a représenté le substrat semiconducteur 10 sans les éléments de circuit qu'il incorpore, sur lequel on a déposé, en une seule fois, la couche isolante 12 (épaisseur d'environ un micron) devant servir de support à la couche d'interconnexion.

Une ouverture de contact 16 de largeur a, correspondant à la largeur de contact désirée, a été creusée dans la couche isolante, de préférence par gravure anisotrope verticale. Cette largeur a est de préférence comprise entre un et deux microns environ pour une épaisseur de couche isolante 12 de un micron environ.

On dépose, par décomposition chimique en phase gazeuse ayant un fort pouvoir de recouvrement des surfaces verticales comme des surfaces horizontales, une couche conductrice 18. L'épaisseur e déposée est telle que la totalité du volume de l'ouverture 16 soit remplie de matière conductrice et que cette épaisseur, telle qu'elle apparaît à l'aplomb de la couche isolante soit bien inférieure à l'épaisseur E présente à l'aplomb de l'ouverture de contact 16 (figure 4).

Le matériau conducteur déposé par décomposition chimique est de préférence du silicium polycristallin dopé. Il peut être aussi un autre métal (tungstène, molybdène, titane, voire de l'aluminium).

Ce matériau est alors gravé uniformément, par gravure anisotrope verticale sans masque, donc aussi bien au-dessus de la couche isolante 12 qu'au-dessus de l'ouverture de contact 16. La gravure est faite de manière à éliminer une épaisseur e seulement, de sorte qu'on dénude la couche isolante en laissant pratiquement remplie d'une épaisseur E-e l'ouverture de contact 16 (figure 5). L'arrêt de la gravure est défini soit par un contrôle précis de la durée de gravure soit par une détection de fin d'attaque par un moyen quelconque (variation de pression ou de couleur des gaz résultant de l'attaque).

On dépose alors classiquement par pulvérisation la couche d'interconnexion proprement dite 14 (en aluminium ou alliage d'aluminium notamment) ; il n'y a plus de passage abrupt de marche (figure 6).

Cette couche peut être gravée (figure 7) pour définir le motif d'interconnexion désiré.

Si on veut réduire au minimum la largeur et le pas entre conducteurs voisins, on peut très bien prévoir avec le procédé selon l'invention que le conducteur ne recouvre pas totalement, après sa gravure, la largeur de l'ouverture de contact : ceci est illustré à la figure 8.

Ainsi, si pour des raisons de résistivité des conducteurs, de résistivité du contact, et de finesse de gravure, on prévoit que la largeur minimale du conducteur est a et l'espacement entre deux conducteurs voisins est d, on peut très bien prévoir que l'ouverture de contact a une largeur a' supérieure à a, avec une marge suffisante tenant compte des imprécisions de superposition des masques successifs définissant les ouvertures de contact et les conducteurs passant au-dessus de ces conducteurs. Par exemple $a' = b$ ; dans ce cas, on voit que le pas entre conducteurs voisins peut être $a + d$ alors qu'il était $c + d$ à la figure 2 et que c était nettement supérieur à a.

Enfin, on peut noter que le procédé selon l'invention permet, si on le désire, de réduire l'épaisseur de métal d'interconnexion, car cette épaisseur n'est plus nécessairement égale a l'épaisseur de la couche isolante comme c'était le cas dans la technique antérieure.

Il permet aussi la prise de contacts entre un deuxième niveau d'interconnexion d'aluminium et le substrat, contact qu'il est difficile de réaliser à cause de la grande épaisseur d'isolant qui sépare le substrat du deuxième niveau d'aluminium. Ceci n'est toutefois possible que si le dépôt par décomposition chimique en phase gazeuse est effectué a une température compatible avec l'intégrité des couches sous-jacentes.

**Revendications** (pour les Etats contractants : DE, FR, GB, IT)

1. Procédé de fabrication d'une couche d'interconnexion (14) dans un circuit intégré, comprenant les étapes consistant à déposer une couche isolante (12) relativement épaisse sur un substrat (10) incorporant des éléments de circuit intégré déjà réalisés, graver une ouverture de contact étroite (16) dans cette couche, déposer par évaporation et graver un métal d'interconnexion (14), caractérisé en ce que, après la gravure des ouvertures de contact étroites (16) et avant le dépôt par évaporation du métal d'interconnexion (14),

on dépose, de façon à obtenir un fort pouvoir couvrant sur les surfaces verticales comme sur les surfaces horizontales, par décomposition chimique en phase gazeuse un matériau conducteur (18) à l'exception du silicium polycristallin, le dépôt étant effectué sur une épaisseur (e) suffisante pour que la totalité du volume de l'ouverture de contact étroite soit remplie de matériau conducteur et pour que l'épaisseur (E) de ce matériau à l'aplomb de l'ouverture soit nettement supérieure à l'épaisseur (e) audessus de la couche isolante,

on grave alors ce matériau par gravure anisotrope verticale, sur une épaisseur uniforme (e) correspondant sensiblement à l'épaisseur déposée sur l'ensemble de la couche isolante, de manière à éliminer le matériau conducteur en dehors de l'ouverture en ne l'éliminant que dans une faible proportion à l'intérieur de l'ouverture.

2. Procédé de fabrication selon la revendication 1, caractérisé en ce que le matériau conducteur est du tungstène, ou du molybdène, ou du titane.

3. Procédé de fabrication selon la revendication 1, caractérisé en ce que les dimensions latérales des ouvertures étroites sont comprises entre un et deux microns environ pour une épaisseur de couche isolante de un micron environ.

**Revendications** (pour l'Etat contractant NL)

1. Procédé de fabrication d'une couche d'interconnexion (14) dans un circuit intégré, comprenant les étapes consistant à déposer une couche isolante (12) relativement épaisse sur un substrat (10) incorporant des éléments de circuit intégré déjà réalisés, graver une ouverture de contact étroite (16) dans cette couche, déposer par évaporation et graver un métal d'interconnexion (14), caractérisé en ce que, après la gravure des ouvertures de contact étroites (16) et avant le dépôt par évaporation du métal d'interconnexion (14),

on dépose, de façon à obtenir un fort pouvoir couvrant sur les surfaces verticales comme sur les surfaces horizontales, par décomposition chimique en phase gazeuse un matériau conducteur (18), le dépôt étant effectué sur une épaisseur (e) suffisante pour que la totalité du volume de l'ouverture de contact étroite soit remplie de matériau conducteur et pour que l'épaisseur (E) de ce matériau à l'aplomb de l'ouverture soit nettement supérieure à l'épaisseur (e) au-dessus de la couche isolante,

on grave alors ce matériau par gravure anisotrope verticale, sur une épaisseur uniforme (e) correspondant sensiblement à l'épaisseur déposée sur l'ensemble de la couche isolante, de manière à éliminer le matériau conducteur en dehors de l'ouverture en ne l'éliminant que dans une faible proportion à l'intérieur de l'ouverture.

2. Procédé de fabrication selon la revendication 1, caractérisé en ce que le matériau conducteur est du silicium polycristallin, ou du tungstène, ou du molybdène, ou du titane.

3. Procédé de fabrication selon la revendication 1, caractérisé en ce que les dimensions latérales des ouvertures étroites sont comprises entre un et deux microns environ pour une épaisseur de couche isolante de un micron environ.

**Claims** (for the Contrating States : DE, FR, GB, IT)

1. A process for producing an interconnecting layer (14) in an integrated circuit comprising the stages consisting of depositing a relatively thick insulating layer (12) on a substrate (10) incorporating the already formed components of the integrated circuit, etching a narrow contact opening (16) in this layer, and depositing by evaporation and etching an interconnecting metal (14), characterized in that after the etching of the narrow contact openings (16) and before the deposition of the interconnecting metal (14),

a conducting material (18), other than polycrystalline silicon, is deposited, by chemical decomposition in the gaseous phase, so as to obtain a high degree of cover capacity on the vertical surfaces as well as on the horizontal surfaces, deposition being effected to a thickness (e) sufficient for the entire volume of the narrow contact opening to be filled with conducting material and for the thickness (E) of this material in line with the opening to be considerably greater than the thickness (e) above the insulating layer,

this material is then etched by vertical anisotropic etching to a uniform depth (e) corresponding substantially to the thickness deposited on the whole of the insulating layer, so as to remove the conducting material outside the opening whilst removing only a small proportion of that inside the opening.

2. A production process according to Claim 1, characterized in that the conducting material is tungsten, molybdenum or titanium.

3. A production process according to Claim 1, characterized in that the lateral dimensions of the narrow contact openings are between about one and two microns for an insulating layer thickness of about one micron.

**Claims** (for the Contracting State NL)

1. A process for producing an interconnecting layer (14) in an integrated circuit comprising the stages consisting of depositing a relatively thick insulating layer (12) on a substrate (10) incorporating the already formed components of the integrated circuit, etching a narrow contact opening (16) in this layer, and depositing by evaporation and etching an interconnecting metal (14), characterized in that after the etching of the narrow contact openings (16) and before the deposition of the interconnecting metal (14),

a conducting material (18) is deposited, by chemical decomposition in the gaseous phase, so as to obtain a high degree of cover capacity on the vertical surfaces as well as on the horizontal surfaces, deposition being effected to a thickness (e) sufficient for the entire volume of the narrow contact opening to be filled with conducting material and for the thickness (E) of this material in line with the opening to be considerably greater than the thickness (e) above the insulating layer,

this material is then etched by vertical anisotropic etching to a uniform depth (e) corresponding substantially to the thickness deposited on the whole of the insulating layer, so as to remove the conducting material outside the opening whilst removing only a small proportion of that inside the opening.

2. A production process according to Claim 1, characterized in that the conducting material is polycrystalline silicon, tungsten, molybdenum or titanium.

3. A production process according to Claim 1, characterized in that the lateral dimensions of the narrow contact openings are between about one and two microns for an insulating layer thickness of about one micron.

**Patentansprüche** (für die Vertragsstaaten : DE, FR, GB, IT)

1. Verfahren zur Herstellung einer Verbindungsschicht (14) in einer integrierten Schaltung, das folgende Schritte umfaßt :

Abscheiden einer relativ dicken Isolationsschicht (12) auf einem Susbtrat (10), das bereits erzeugte Elemente der integrierten Schaltung enthält, Ätzen einer engen Kontaktöffnung (16) in diese Schicht, Abscheiden eines Verbindungsmetalls (14) durch Bedampfen und Ätzen desselben, dadurch gekennzeichnet, daß nach dem Ätzen der engen Kontaktöffnungen (16) und vor dem Abscheiden des Verbindungsmetalls (14) durch Bedampfen folgende Schritte vorgenommen werden :

man scheidet durch chemische Zersetzung in der Gasphase ein Leitermaterial (18) mit Ausnahme von polykristallinem Silizium so ab, daß man ein starkes Bedeckungsvermögen sowohl auf den vertikalen als auch auf den horizontalen Oberflächen erzielt, wobei die Abscheidung mit einer Dicke (e) erfolgt, die ausreicht, um das gesamte Volumen der engen Kontaktöffnung mit dem Leitermaterial auszufüllen und zu bewirken, daß die Dicke (e) dieses Materials senkrecht zur Öffnung deutlich größer ist als die Dicke (e) über der Isolationsschicht, und

man ätzt hierauf dieses Material mit einer anisotropen vertikalen Ätzung um eine gleichförmige Dicke (e) ab, die genau der auf der Gesamtheit der Isolationsschicht abgeschiedenen Dicke entspricht, so daß man das Leitermaterial außerhalb der Öffnung entfernt, es innerhalb der Öffnung jedoch nur zu einem ganz geringen Teil beseitigt.

2. Herstellungsverfahren nach Anspruch 1, dadurch gekennzeichnet, daß das Leitermaterial aus Wolfram oder Molybdän oder Titan besteht.

3. Herstellungsverfahren nach Anspruch 1, dadurch gekennzeichnet, daß die seitlichen Abmessungen der engen Öffnungen für eine Dicke der isolierenden Schicht von ungefähr 1 μm zwischen einem und zwei μm liegen.

**Patentansprüche** (für den Vertragsstaat NL)

1. Verfahren zur Herstellung einer Verbindungsschicht (14) in einer integrierten Schaltung, das folgende Schritte umfaßt :

Abscheiden einer relativ dicken Isolationsschicht (12) auf einem Substrat (10), das bereits erzeugte Elemente der integrierten Schaltung enthält, Ätzen einer engen Kontaktöffnung (16) in diese Schicht,

5

Abscheiden eines Verbindungsmetalls (14) durch Bedampfen sowie Ätzen desselben, dadurch gekennzeichnet, daß nach dem Ätzen der engen Kontaktöffnungen (16) und vor dem Abscheiden des Verbindungsmetalls (14) durch Bedampfen folgende Schritte vorgenommen werden :

man scheidet durch chemische Zersetzung in der Gasphase ein Leitermaterial (18) so ab, daß man ein starkes Bedeckungsvermögen sowohl auf den vertikalen als auch auf den horizontalen Oberflächen erzielt, wobei die Abscheidung mit einer Dicke (e) erfolgt, die ausreicht, um das gesamte Volumen der engen Kontaktöffnung mit dem Leitermaterial auszufüllen und zu bewirken, daß die Dicke (E) dieses Materials senkrecht zur Öffnung deutlich größer ist als die Dicke (e) über der Isolationsschicht, und

man ätzt hierauf dieses Material mit einer anisotropen vertikalen Ätzung um eine gleichförmige Dicke (e) ab, die genau der auf der Gesamtheit der Isolationsschicht abgeschiedenen Dicke entspricht, so daß man das Leitermaterial außerhalb der Öffnung entfernt, es innerhalb der Öffnung jedoch nur zu einem ganz geringen Teil beseitigt.

2. Herstellungsverfahren nach Anspruch 1, dadurch gekennzeichnet, daß das Leitermaterial aus polykristallinem Silizium oder aus Wolfram oder Molybdän oder Titan besteht.

3. Herstellungsverfahren nach Anspruch 1, dadurch gekennzeichnet, daß die seitlichen Abmessungen der engen Öffnungen für eine Dicke der isolierenden Schicht von ungefähr 1 μm zwischen einem und zwei μm liegen.

# FIG_1

# FIG_2

# FIG_3

# FIG_4

# FIG_5

# FIG_6

# FIG_7

# FIG_8